(19) **Europäisches Patentamt / European Patent Office / Office européen des brevets**

(11) **EP 4 300 110 B1**

(12) **EUROPEAN PATENT SPECIFICATION**

(45) Date of publication and mention
of the grant of the patent:
**18.06.2025 Bulletin 2025/25**

(21) Application number: **22876703.4**

(22) Date of filing: **06.09.2022**

(51) International Patent Classification (IPC):
**G01R 31/367** (2019.01) **G01R 31/392** (2019.01)
**G01R 31/52** (2020.01) **G01R 31/14** (2006.01)
**G01R 31/382** (2019.01) **G01R 27/02** (2006.01)
**G01R 27/26** (2006.01) **G01R 31/396** (2019.01)
**H02J 7/00** (2006.01)

(52) Cooperative Patent Classification (CPC):
**G01R 31/52; G01R 31/367; H02J 7/00304;**
Y02E 60/10

(86) International application number:
**PCT/KR2022/013339**

(87) International publication number:
**WO 2023/054928 (06.04.2023 Gazette 2023/14)**

(54) **SHORT-CIRCUIT CURRENT PREDICTION DEVICE AND METHOD**

KURZSCHLUSSSTROMVORHERSAGEVORRICHTUNG UND -VERFAHREN

DISPOSITIF ET PROCÉDÉ DE PRÉDICTION DE COURANT DE COURT-CIRCUIT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.10.2021 KR 20210130860**

(43) Date of publication of application:
**03.01.2024 Bulletin 2024/01**

(73) Proprietor: **LG Energy Solution, Ltd.
Seoul 07335 (KR)**

(72) Inventors:
• **MUN, Byeongho
Daejeon 34122 (KR)**
• **KONG, Sung Shik
Daejeon 34122 (KR)**
• **CHO, Hangjin
Daejeon 34122 (KR)**

(74) Representative: **Plasseraud IP
104 Rue de Richelieu
CS92104
75080 Paris Cedex 02 (FR)**

(56) References cited:
**CN-A- 111 198 327      CN-A- 111 257 753
CN-A- 111 585 270      CN-A- 112 147 512
KR-A- 20210 054 930    KR-B1- 101 930 647**

• **GATTA F M ET AL: "Arc-flash in large battery
energy storage systems - Hazard calculation and
mitigation", 2016 IEEE 16TH INTERNATIONAL
CONFERENCE ON ENVIRONMENT AND
ELECTRICAL ENGINEERING (EEEIC), IEEE, 7
June 2016 (2016-06-07), pages 1 - 6,
XP032954625, DOI: 10.1109/EEEIC.2016.7555442**

**Description**

The present invention relates to a short-circuit current prediction apparatus and method, and more particularly, to a short-circuit current prediction apparatus and method for predicting in advance a magnitude of a short-circuit current generated in a battery system.

[Background Art]

An energy storage system relates to renewable energy, a battery that stores electric power, and a power grid. Recently, as a spread of smart grid and renewable energy is expanding and efficiency and stability of the power system are emphasized, a demand for energy storage systems for power supply and demand control and power quality improvement is increasing. Depending on a purpose of use, energy storage systems may have different outputs and capacities. In order to configure a large-capacity energy storage system, a plurality of battery systems may be connected.

Meanwhile, a battery condition management is essential for continuous energy storage system (ESS) service.

For this, the energy storage system requires information on the battery system, such as a voltage of the battery and whether a battery fuse is blown. However, since the battery system is provided in a structure in which a plurality of battery cells and various elements are connected, it is not easy to determine whether a problem is with the battery fuse or other elements when charging or discharging is not performed. Furthermore, when predicting short-circuit current, electrical characteristics of the battery are not considered and a magnitude of the short-circuit current blocked by the fuse cannot be predicted.

Accordingly, in order to design a battery protection system, an experiment for measuring a maximum short-circuit current is essentially performed. However, this has disadvantages that are accompanied by problems of high cost and high risk.

GATTAF M ET AL: "Arc-flash in large battery energy storage systems - Hazard calculation and mitigation", 2016 IEEE 16TH INTERNATIONAL CONFERENCE ON ENVIRONMENT AND ELECTRICAL ENGINEERING (EEEIC), IEEE, 7 June 2016 (2016-06-07), pages 1-6, XP032954625, DOI: 10.1109/EEEIC. 2016.7555442 deals with the arc-flash hazard calculation in battery energy storage systems.

CN 111 585 270 A discloses a marine DC grid-connected system and a simulation method for short-circuit protection thereof.

[Summary]

[Technical Problem]

In order to solve the problem, an object of the present invention is to provide a high-efficiency and low-cost short-circuit current prediction apparatus that can determine a voltage of a battery and whether a fuse is blown.

In order to solve the problem, another object of the present invention is to a method for predicting a short-circuit current with high efficiency and low cost that can determine a voltage of a battery and whether a fuse is blown.

[Technical Solution]

In order to achieve the objective of the present disclosure, an apparatus for predicting a short-circuit current in a battery system including a battery and a fuse for protecting the battery may comprise at least one processor; and a memory configured to store at least one instruction executed by the at least one processor, wherein the at least one instruction includes an instruction to derive an internal equivalent circuit of the battery that reflects a short circuit condition in a DC(Direct Current) circuit; an instruction to derive a first equivalent circuit in consideration of one or more electrical characteristics of the battery; an instruction to derive a second equivalent circuit in consideration of one or more electrical characteristics of the fuse; an instruction to obtain a short-circuit current prediction model by reflecting the first equivalent circuit and the second equivalent circuit based on the internal equivalent circuit; and an instruction to predict the short-circuit current according to a battery voltage using the short-circuit current prediction model.

The first equivalent circuit may include a circuit in which a first resistor and a second resistor are connected in series in the battery, the second resistor being connected in parallel with a capacitor.

The second equivalent circuit may include a switch and a circuit in which a resistor and a capacitor of the fuse are connected in series.

The switch may represent a first state in which a conductor starts to melt by heat generated inside the fuse before an arc occurs or a second state in which the conductor melted due to occurrence of an arc and a current flows into the air, according to an on/off state of the switch.

The instruction to obtain the short-circuit current prediction model may include an instruction to formulate the first equivalent circuit; an instruction to formulate the second equivalent circuit; and an instruction to obtain the short-circuit current prediction model according to the first state or the second state by reflecting the formulated first equivalent circuit and the second equivalent circuit in the internal equivalent circuit and using short-circuit occurrence experimental data.

The internal equivalent circuit may include an internal resistor and an internal inductor of the battery based on an RL circuit.

The short-circuit current prediction model in the first state may include one or more mechanical characteristics of the battery in a transient state and the short-circuit current prediction model in the second state may include one or more mechanical characteristics of the battery in the transient state and one or more chemical characteristics of the battery in a stationary state.

According to another embodiment of the present disclosure, a method for predicting a short-circuit current in a battery system including a battery and a fuse for protecting the battery may comprise deriving an internal equivalent circuit of the battery that reflects a short circuit condition in a DC(Direct Current) circuit; deriving a first equivalent circuit in consideration of one or more electrical characteristics of the battery; deriving a second equivalent circuit in consideration of one or more electrical characteristics of the fuse; obtaining a short-circuit current prediction model by reflecting the first equivalent circuit and the second equivalent circuit based on the internal equivalent circuit; and predicting a short-circuit current according to a battery voltage using the short-circuit current prediction model.

The first equivalent circuit may include a circuit in which a first resistor and a second resistor are connected in series in the battery, the second resistor being connected in parallel with a capacitor.

The second equivalent circuit may include a switch and a circuit in which a resistor and a capacitor of the fuse are connected in series.

The switch may represent a first state in which a conductor starts to melt by heat generated inside the fuse before an arc occurs or a second state in which the conductor melted due to occurrence of an arc and a current flows into the air, according to an on/off state of the switch.

The obtaining the short-circuit current prediction model may include formulating the first equivalent circuit; formulating the second equivalent circuit; and obtaining the short-circuit current prediction model according to the first state or the second state by reflecting the formulated first equivalent circuit and the second equivalent circuit in the internal equivalent circuit and using short-circuit occurrence experimental data.

The internal equivalent circuit may include an internal resistor and an internal inductor of the battery based on an RL circuit.

The short-circuit current prediction model in the first state may include one or more mechanical characteristics of the battery in a transient state and the short-circuit current prediction model in the second state may include one or more mechanical characteristics of the battery in the transient state and one or more chemical characteristics of the battery in a stationary state.

[Advantageous Effects]

According to embodiments of the present disclosure, the short-circuit current prediction apparatus and method may derive an internal equivalent circuit of the battery that reflects a short circuit condition in a DC, derive a first equivalent circuit in consideration of electrical characteristics of the battery, derive a second equivalent circuit in consideration of electrical characteristics of the fuse, obtain a short-circuit current prediction model by reflecting the first equivalent circuit and the second equivalent circuit based on the internal equivalent circuit, and predict the short-circuit current according to a battery voltage using the short-circuit current prediction model. Thus, high-precision short-circuit current prediction is possible in units of battery modules, racks, and systems (banks) in consideration of both mechanical and chemical characteristics of a parallel-connected battery system and based on previously acquired short-circuit occurrence experimental data, thereby providing a high-efficiency and low-cost short-circuit current prediction apparatus and method that can be used to determine a maximum number of parallel connections of batteries while developing a battery system, and thus, reducing a number of short-circuit occurrence experiments and preventing a delay of development schedule.

[Brief Description of the Drawings]

FIG. 1 is a schematic circuit diagram of a short circuit accident of a battery.
FIG. 2 is a flowchart illustrating a conventional design process of a battery protection unit.
FIG. 3 is a block diagram of a short-circuit current prediction apparatus according to embodiments of the present invention.
FIG. 4 is an equivalent model circuit diagram in a battery system in a short-circuit state according to embodiments of the present invention.

FIG. 5 is a flowchart of a short-circuit current prediction method according to embodiments of the present invention.

FIG. 6 is an internal equivalent circuit diagram of a short-circuit current prediction apparatus according to embodiments of the present invention.

FIG. 7 is a graph illustrating a voltage-current characteristic according to switch control in an internal equivalent circuit according to embodiments of the present invention.

FIG. 8 is a first equivalent circuit diagram reflecting electrical characteristics of a battery according to embodiments of the present invention.

FIG. 9 is a second equivalent circuit diagram reflecting electrical characteristics of a fuse in a battery protection unit according to embodiments of the present invention.

FIG. 10 shows voltage-current graphs of the first equivalent circuit according to a state of a battery according to embodiments of the present invention.

FIG. 11 shows voltage-current graphs in a first state or a second state according to a switching state in a second equivalent circuit according to embodiments of the present invention.

FIG. 12 shows voltage-current change graphs according to a short-circuit state of a fuse according to embodiments of the present invention.

FIG. 13 is a flowchart for calculating parameter values of a short-circuit current prediction model according to embodiments of the present invention.

FIG. 14 is a graph showing a short circuit occurrence experiment in which a voltage-current change of the battery is measured according to a state of the fuse, according to embodiments of the present invention.

1000:     memory
2000:     processor
3000:     transceiver
4000:     input interface
5000:     output interface
6000:     storage device
7000:     bus

[Detailed Description]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific embodiments, and are not intended to limit the present invention. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

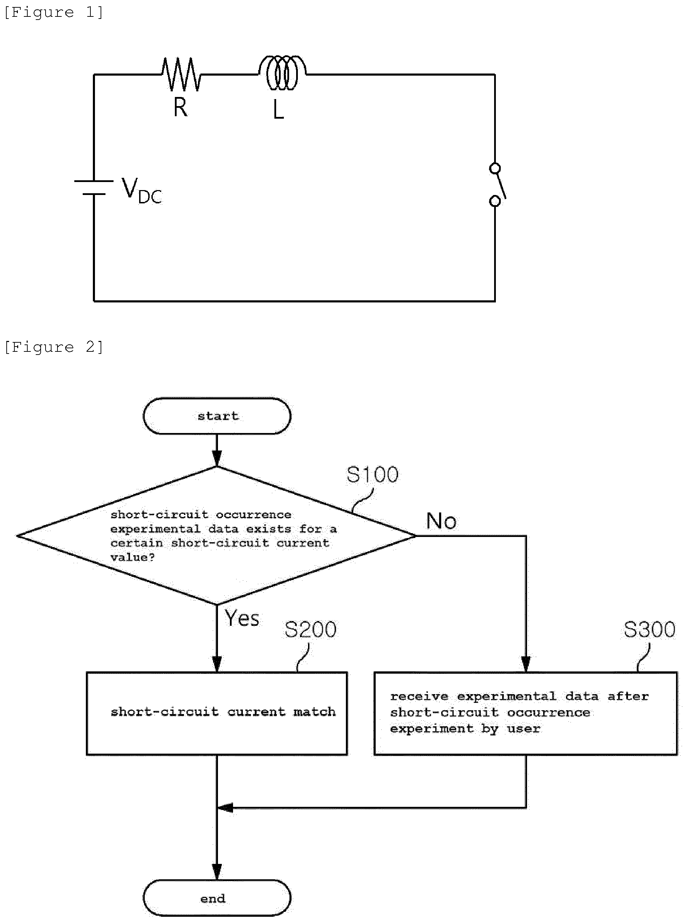

FIG. 1 is a schematic circuit diagram of a short circuit accident of a battery.

Referring to FIG. 1, a conventional battery protection device protects a battery from a short-circuit current by controlling an on/off operation of a fuse when a short-circuit accident occurs. Here, the short circuit accident may be an accident in which the positive and negative poles of the battery are connected and an overcurrent flows.

In general, a conventional battery protection device predicts a maximum short-circuit current in a transient state by considering only a basic RL equivalent circuit in which a basic resistor (R) and an inductor (L) are connected in series when calculating the short-circuit current.

In other words, the conventional battery protection device does not consider any electrical characteristics of the battery when calculating the short-circuit current in the battery system, and also does not consider a short-circuit current blocked by a fuse. Accordingly, the conventional battery protection device has a disadvantage in that a large error occurs when calculating the maximum short-circuit current, thereby causing a damage to the battery and reducing reliability.

Accordingly, in the prior art, a number of short-circuit occurrence experiments were separately conducted in order to calculate the maximum short-circuit current that can be cut off by operation control of a fuse before designing a battery protection device.

FIG. 2 is a flowchart illustrating a conventional design process of a battery protection device.

Referring to FIG. 2, a conventional battery protection device predicts a maximum short-circuit current based on a magnitude of a short-circuit current calculated through a basic RL equivalent circuit, and checks if short-circuit occurrence experimental data performed in advance exists for the predicted maximum short-circuit current value (S100). Then, the maximum short-circuit current value is the confirmed by checking if a short circuit has occurred according to the corresponding short-circuit current value (S200).

On the other hand, if there is no experimental data previously conducted for the predicted maximum short-circuit current value, a user performs a short-circuit occurrence experiment for the assumed maximum short-circuit current (S300). Furthermore, it is checked whether the short-circuit occurrence is a controllable short-circuit current by the fuse, and the maximum short-circuit current value is determined based on experimental results and is reflected in the conventional battery protection device.

However, the conventional design method for battery protection requires a long time and a high cost because a number of experiments are required to calculate an optimal short-circuit current value.

Accordingly, the present invention provides an equivalent circuit model in consideration of electrical characteristics of the battery, internal circuit characteristics, and electrical characteristics of the fuse in a battery protection device (BPU), thereby predicting a high-precision short-circuit current value. Thus, the present invention provides a high-efficiency and low-cost short-circuit current prediction apparatus and method that reduces a number of short-circuit occurrence experiments performed when designing a protection device and prevents delays in a development schedule by being used to determine a maximum number of parallel connections of batteries during a development of a battery system.

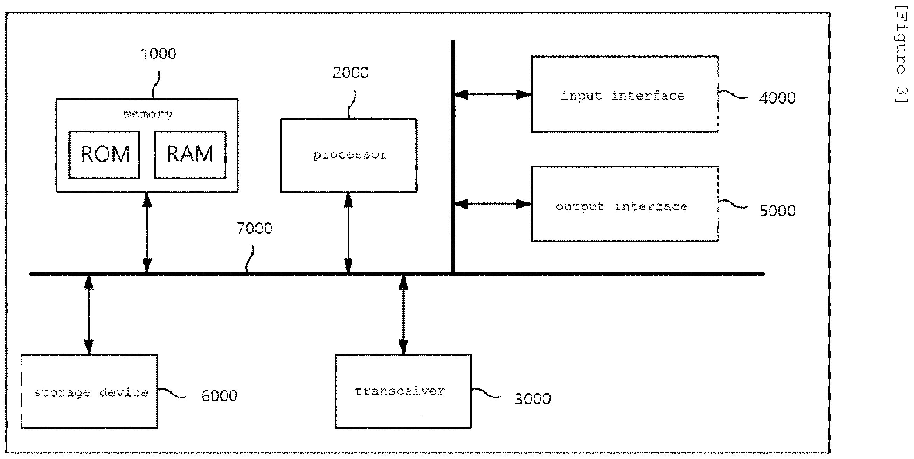

FIG. 3 is a block diagram of a short-circuit current prediction apparatus according to embodiments of the present invention.

Referring to FIG. 3, a short-circuit current prediction apparatus according to embodiments of the present invention may predict in advance a magnitude of a short-circuit current generated in a battery system according to a magnitude of a battery voltage.

For example, the short-circuit current prediction apparatus may be used when designing a battery protection device in an energy storage system (ESS) to prevent a short-circuit accident occurring in a battery system in the energy storage system in advance.

More specifically, the short-circuit current prediction apparatus predicts a short-circuit current value for each component in a battery system in which at least one battery rack or module is connected in series and parallel through a simulation, so that the short-circuit current value can be applied for a maximum value for controlling operation of a fuse in a battery protection device.

In more details, the short-circuit current prediction apparatus according to embodiments of the present invention may include a memory 1000 for storing at least one instruction, a processor 2000 for executing at least one instruction of the memory, a transceiver 3000, an input interface 4000, an output interface 5000, and a storage device 6000.

According to embodiments, components (1000, 2000, 3000, 4000, 5000, 6000) included in the short-circuit current prediction apparatus may be connected by a bus 7000 to communicate with each other.

Among components (1000, 2000, 3000, 4000, 5000, 6000) in the short-circuit current prediction apparatus, the memory 1000 or the storage device 6000 may be configured as at least one of a volatile storage medium and a nonvolatile storage medium. For example, the memory 1000 or the storage device 6000 may be configured as at least one of a read only memory (ROM) and a random access memory (RAM).

The memory 1000 may include at least one instruction to be executed by the processor 2000 to be described later.

According to embodiments, the at least one instruction may include an instruction to derive an internal equivalent circuit of the battery that reflects a short circuit condition in a DC(direct current) circuit; a instruction to derive a first equivalent circuit in consideration of electrical characteristics of the battery; a instruction to derive a second equivalent circuit in consideration of electrical characteristics of the fuse; an instructions to obtain a short-circuit current prediction model by reflecting the first equivalent circuit and the second equivalent circuit based on the internal equivalent circuit; and an instructions to predict the short-circuit current according to a battery voltage using the short-circuit current prediction model.

Here, the processor 2000 may include a central processing unit (CPU), a graphics processing unit (GPU), or a dedicated processor on which a method according to embodiments of the present invention are performed.

As described above, the processor 2000 may execute at least one program command stored in the memory 1000 .

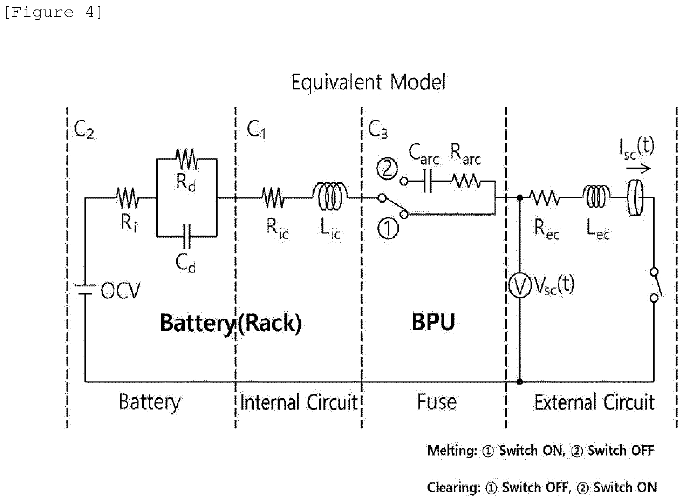

Hereinafter, a method for predicting a short-circuit current executed by a processor in an apparatus for predicting a short-circuit current according to embodiments of the present invention will be described in detail with reference to FIG. 4.

FIG. 4 is an equivalent model circuit diagram in a battery system in a short-circuit state according to embodiments of the present invention.

Referring to FIG. 4, the processor 2000 in a short-circuit current prediction apparatus may calculate an equivalent circuit representing electrical characteristics of a battery system, thereby predicting a short-circuit current in the battery system.

According to an embodiment, the short-circuit current prediction apparatus according to the present invention may obtain a short-circuit current prediction model reflecting internal circuit characteristics, electrical characteristics of the battery, and electrical characteristics of a fuse, based on a RL series circuit reflecting characteristics of a short-circuit state in a DC circuit model. Accordingly, the short-circuit current prediction apparatus may predict a short-circuit current value in a battery system by using the obtained short-circuit current prediction model.

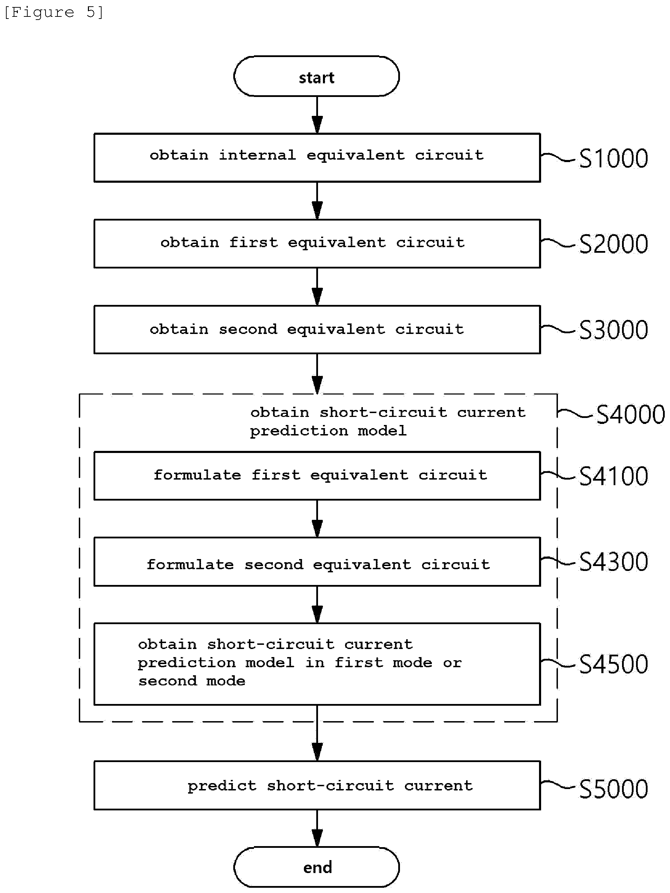

In FIG. 5 below, operations of the processor 2000 will be described in more detail in order.

FIG. 5 is a flowchart of a short-circuit current prediction method according to embodiments of the present invention.

Referring to FIGs. 4 and 5, the processor 2000 may obtain a short-circuit current prediction model in a battery system reflecting internal circuit characteristics of the battery, electrical characteristics of the battery, and electrical characteristics of a fuse in a battery protection unit, based on a RL series circuit reflecting characteristics of a short-circuit state in a DC circuit.

Thereafter, the processor 2000 may predict a magnitude of the short-circuit current generated according to a magnitude of a specific voltage, based on the obtained short-circuit current prediction model.

In more detail, the processor 2000 may obtain an internal equivalent circuit of a battery from a RL series circuit reflecting a characteristics of the short-circuit state in a DC circuit S1000. The step of obtaining the internal equivalent circuit will be described in more detail below.

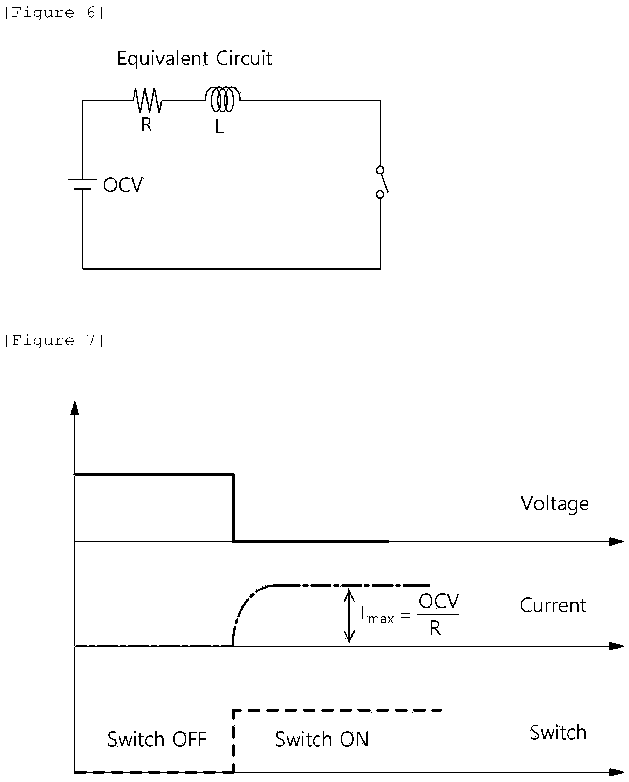

FIG. 6 is an internal equivalent circuit diagram of a short-circuit current prediction apparatus according to embodiments of the present invention.

Referring to FIG. 6, an internal equivalent circuit applied to the short-circuit current prediction apparatus may include an RL series circuit.

More specifically, the internal equivalent circuit of a battery system may be a circuit representing electrical characteristics in the battery system based on a RL series circuit that effectively shows characteristics of a short-circuit state in a DC circuit. For example, the internal equivalent circuit may be configured in a form in which a voltage (OCV), a resistor (R), an inductor (L), and a switch (S) are connected in series. Here, the voltage may be an open circuit voltage (OCV), the resistor R may have an internal resistance value $R_{ic}$, and the inductor L may have an internal inductance value $L_{ic}$.

Here, the RL circuit applied to the short-circuit current prediction apparatus may be the same as the circuit used in a conventional battery protection unit to obtain the maximum short-circuit current.

For example, in the internal equivalent circuit, the maximum current value $I_{max}$ may be determined by a magnitude of the resistance $R_i$ and the open circuit voltage OCV of the battery. In addition, the inductor L may indicate a characteristic of a maximum current flowing in the circuit.

FIG. 7 is a graph illustrating a voltage-current characteristic according to switch control in an internal equivalent circuit according to embodiments of the present invention.

Referring to FIG. 7 , when the internal equivalent circuit is in open state, that is, when the switch is in OFF state, the voltage in the internal equivalent circuit may be kept constant and the current may not flow.

On the other hand, when the internal equivalent circuit is closed, that is, when the switch is ON, the voltage in the internal equivalent circuit is reduced to 0 by the resistor, and thus a current may flow. Here, the maximum current value ($I_{max}$) flowing through the internal equivalent circuit may be expressed as in Equation 1 below.

[Equation 1]

$$I_{\max} = \frac{OCV}{R}$$

$I_{\max}$: Maximum current value flowing through internal equivalent circuit
OCV: Open Circuit Voltage
R: short circuit resistance

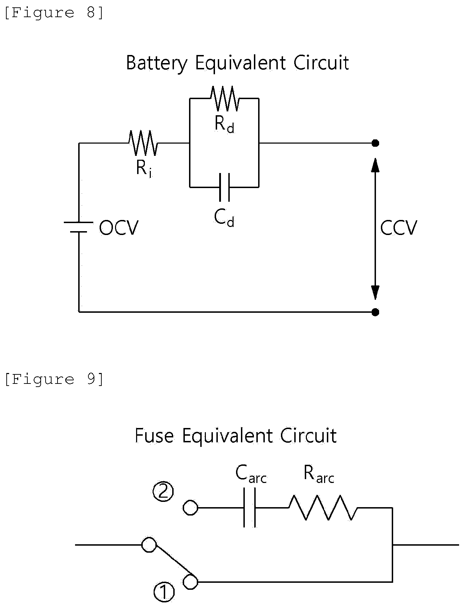

Thereafter, the processor 2000 in the short-circuit current prediction apparatus according to embodiments of the present invention may obtain a first equivalent circuit reflecting electrical characteristics of the battery. A method of obtaining the first equivalent circuit will be described below in more detail with reference to FIG. 8.

FIG. 8 is a first equivalent circuit diagram reflecting electrical characteristics of a battery according to embodiments of the present invention.

Referring to FIG. 8, the processor 2000 may obtain a first equivalent circuit reflecting electrical characteristics of a battery in the battery system S2000.

More specifically, the first equivalent circuit may include a circuit in which a first resistor ($R_i$) representing mechanical properties of the battery and a second resistor ($R_d$) and a capacitor ($C_d$) connected in parallel representing chemical properties of the battery are connected. Here, the second resistor $R_d$ and the capacitor $C_d$ may be connected in parallel, which may be connected in series with the first resistor Ri. Accordingly, the first equivalent circuit may reflect mechanical and chemical properties of a battery in a battery system.

Referring back to FIG. 5, the processor 2000 may obtain a second equivalent circuit in consideration of electrical characteristics of a fuse in a battery protection unit S3000. A method of obtaining the second equivalent circuit will be described in more detail below with reference to FIG. 9.

FIG. 9 is a second equivalent circuit diagram reflecting electrical characteristics of a fuse in a battery protection unit according to embodiments of the present invention.

Referring to FIG. 9, the processor 2000 may obtain a second equivalent circuit reflecting electrical characteristics of a fuse in a battery protection unit of a battery system.

In general, in a battery system, characteristics of voltage and current may change based on occurrence of a short circuit due to an arc. Accordingly, a state of the fuse may be changed from a first state (melting) to a second state (clearing) based on the occurrence of a short circuit.

Here, the first state may be a state in which a conductor starts to melt by heat generated inside the fuse before an arc is generated, and the second state may be a state in which an arc is generated and the conductor is melted so that a current flows into the air.

Accordingly, in order to implement the fusing characteristic of the fuse, the processor 2000 in the short-circuit current prediction apparatus according to embodiments of the present invention may obtain a second equivalent circuit that causes a state transition to occur according to a position of the switch.

More specifically, the second equivalent circuit may include a switch and a circuit in which the resistor $R_{arc}$ and the capacitor $C_{arc}$ are connected in series. Here, the second equivalent circuit may be designed so that the capacitor $C_{arc}$ and the resistor $R_{arc}$ components are reflected or not reflected in the circuit depending on to which state the switch is controlled.

Referring back to FIG. 5, the processor 2000 may obtain a short-circuit current prediction model based on the obtained internal equivalent circuit, the first equivalent circuit, and the second equivalent circuit S4000.

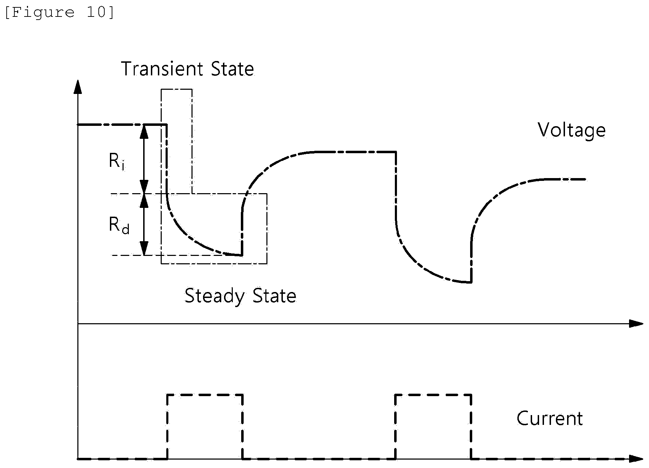

More specifically, the processor 2000 may formulate the first equivalent circuit S4100. A method of formulating the first equivalent circuit will be described in more detail below with reference to FIG. 10.

FIG. 10 shows voltage-current graphs of the first equivalent circuit according to a state of a battery according to embodiments of the present invention.

Referring to FIG. 10, in the first equivalent circuit, when a change in the battery voltage occurs, a current may flow in the capacitor $C_d$.

According to an embodiment, when the battery is in a transient state, the voltage of the battery may be rapidly reduced by a first resistor $R_i$. Accordingly, the capacitor $C_d$ in the first equivalent circuit may operate as if conducting in a transient state. In other words, when the battery is in a transient state, only the series-connected first resistor ($R_i$) component may be considered in the first equivalent circuit as shown in Equations 2 and 3 below.

[Equation 2]

$$I_{Cd} = C\frac{dv}{dt}$$

$I_{Cd}$: current flowing through capacitor

[Equation 3]

$$X_C = \frac{1}{2\pi fc}$$

$X_c$: Capacitive reactance of capacitor

According to another embodiment, when the battery is in a steady state, since charges are accumulated in the capacitor $C_d$ in the first equivalent circuit, the second resistance $R_d$ may increase. Accordingly, the capacitor $C_d$ may operate similarly to an instance in which the conducted current is decreased and then opened.

Accordingly, the processor 2000 in the short-circuit current prediction apparatus according to embodiments of the present invention may obtain a first equation in which all physical and chemical characteristics according to the transient state and the stationary state of the battery are reflected, as shown in Equation 4 below. In other words, the first formula may be a formula in which electrical characteristics of not only series-connected battery cells but also parallel-connected battery modules, battery racks, and battery systems are reflected. Here, the CCV may be a closed circuit voltage, and the battery module and the battery system may be used interchangeably with terms such as a battery pack and a battery bank, respectively.

[Equation 4]

$$CCV = OCV - R_i I(t) - \frac{1}{C}\int (I(t) - \frac{V_d}{R_d})dt$$

CCV:  Closed Circuit Voltage
OCV:  Open Circuit Voltage
$R_i$, $R_d$:  first resistance, second resistance
I:  current
$V_d$:  voltage across second resistor
C:  capacitance

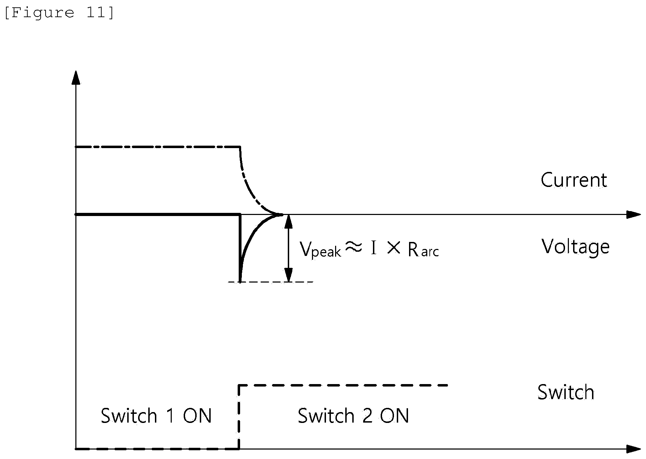

Referring back to FIG. 5, the processor 2000 may formulate the second equivalent circuit S4300. A method of formulating the second equivalent circuit will be described in more detail below with reference to FIG. 11.

FIG. 11 shows voltage-current graphs in a first state or in a second state according to a switching state in a second equivalent circuit according to embodiments of the present invention.

Referring to FIG. 11, in the second equivalent circuit, a state of the fuse may be transitioned according to a state of the switch.

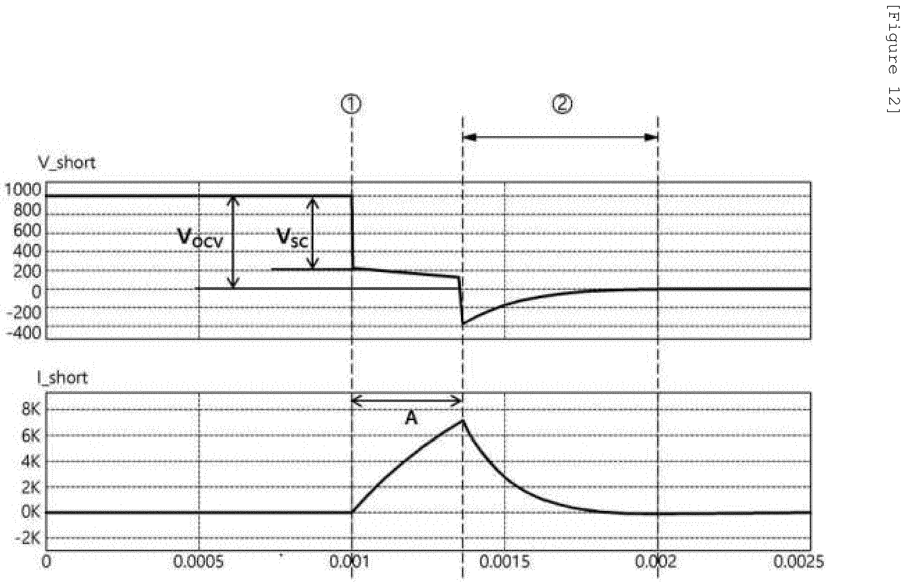

FIG. 12 shows voltage-current change graphs according to a short-circuit state of a fuse according to embodiments of the present invention.

Referring to FIGs. 11 and 12, in the second equivalent circuit according to an exemplary embodiment, when the switch is in ① state, a first state (Melting) may be represented.

More specifically, in the first state, since components of the capacitor $C_{arc}$ and the resistor $R_{arc}$ in the circuit are not reflected, a voltage may not be applied and a current may flow.

In the second equivalent circuit according to another embodiment, when the switch is in ② state, a second state (Clearing) may be represented.

More specifically, in the second state, charges may be accumulated in the capacitor $C_{arc}$, so that the current may decrease. When the accumulation of the capacitor $C_{arc}$ is completed, the second equivalent circuit may be opened.

Here, a counter electromotive force ($V_{peak}$) may be generated in the second equivalent circuit. The counter electromotive force may be generated as shown in Equation 5 below by an inductance component in the second equivalent circuit.

[Equation 5]

$$V_{peak} \approx I \times R_{arc}$$

$V_{peak}$: counter electromotive force
$R_{arc}$: resistance inside fuse

Here, the switch may be switched when a state transition occurs from the first state to the second state based on a preset threshold value. For example, the threshold value is a value obtained by multiplying a square of the current ($I_2$) by the time (t), and may be calculated based on a data sheet of a fuse or short circuit occurrence experimental data.

Referring back to FIG. 5, the processor 2000 may reflect the formulated first equivalent circuit and the second equivalent circuit in the internal equivalent circuit, and obtain a short-circuit current prediction model that may be provided in a first mode or a second mode according to a state of the fuse in a short-circuit occurrence (S4500). Here, the short-circuit current prediction model may be a model that represents values of short-circuit voltage and short-circuit current in mathematical expressions, wherein the short-circuit voltage and the short-circuit current are generated in a battery system according to a state of a fuse when the short circuit occurs.

A method of obtaining the short-circuit current prediction model will be described in more detail. The processor 2000 may combine the internal equivalent circuit, and the formulated first and the second equivalent circuits according to a short-circuit state of the fuse.

According to an embodiment, the processor 2000 may obtain a short-circuit current prediction model in a first mode by reflecting the internal equivalent circuit in the first equivalent circuit equation representing electrical characteristics of the battery in a transient state and the second equivalent circuit equation representing electrical characteristics of the fuse in a first state (melting).

The short-circuit current prediction model in the first mode may be expressed as Equation 6 below.

[Equation 6]

$$V_{sc(t)} = OCV - (R_i + R_{ic})I(t) - L_{ic}\frac{dI(t)}{dt}$$

$$I_{SC}(t) = \frac{OCV}{R_i + R_{ic} + R_{ec}}\left(1 - e^{\frac{R_i + R_{ic} + R_{ec}}{L_{ic} + L_{ec}}t}\right)$$

$V_{sc}$: short-circuit voltage in first mode
$I_{sc}$: short-circuit current in first mode
$R_i$: first resistance
$R_{ic}$: internal resistance
$R_{ec}$: external resistance
$L_{ic}$: internal inductance
$L_{ec}$: external inductance
$C_{arc}$: capacitance inside fuse
$R_{arc}$: resistance inside fuse

The processor 2000 may obtain a short-circuit current prediction model in a second mode by reflecting the internal equivalent circuit in the first equivalent circuit equation representing electrical characteristics of the battery in a steady state and the second equivalent circuit equation representing electrical characteristics of the fuse in a second state (clearing).

The short-circuit current prediction model in the second mode may be expressed as equation 7 below.

[Equation 7]

$$V_{SC}(t) = OCV - (R_i + R_{ic})I(t) - L_{ic}\frac{dI(t)}{dt} - \frac{1}{C_{arc}}\int I(t)dt - R_{arc}I(t)$$

$$I_{SC}(t) \approx \frac{V_{fuse}}{R_{arc}}\left(e^{-\frac{1}{R_{arc}C_{arc}}t}\right)$$

$V_{sc}$:     short-circuit voltage in second mode
$I_{sc}$:     short-circuit current in second mode
$R_i$:     first resistance
$R_{ic}$:     internal resistance
$L_{ic}$:     internal inductance
$L_{ec}$:     external inductance
$C_{arc}$:     capacitance inside fuse
$R_{arc}$:     resistance inside fuse
$V_{fuse}$:     voltage inside fuse

Thereafter, the processor 2000 may calculate parameter values of the short-circuit current prediction model in the first mode or the second mode to predict the short-circuit current according to the battery voltage S5000.

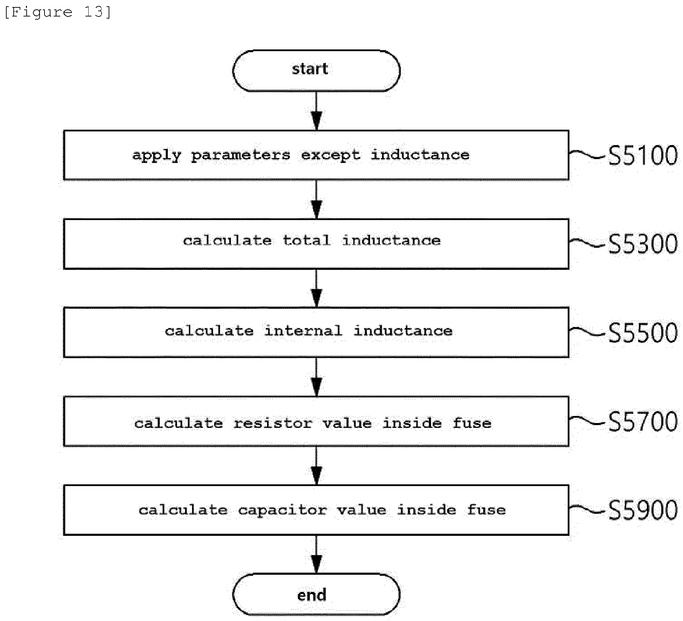

A method of calculating the parameter values of the short-circuit current prediction model will be described in more detail below with reference to FIG. 13.

FIG. 13 is a flowchart for calculating parameter values of a short-circuit current prediction model according to embodiments of the present invention.

Referring to FIG. 13, the processor 2000 may apply parameter values except the inductance L in the short-circuit current prediction model by using previously acquired short-circuit occurrence experimental data S5100.

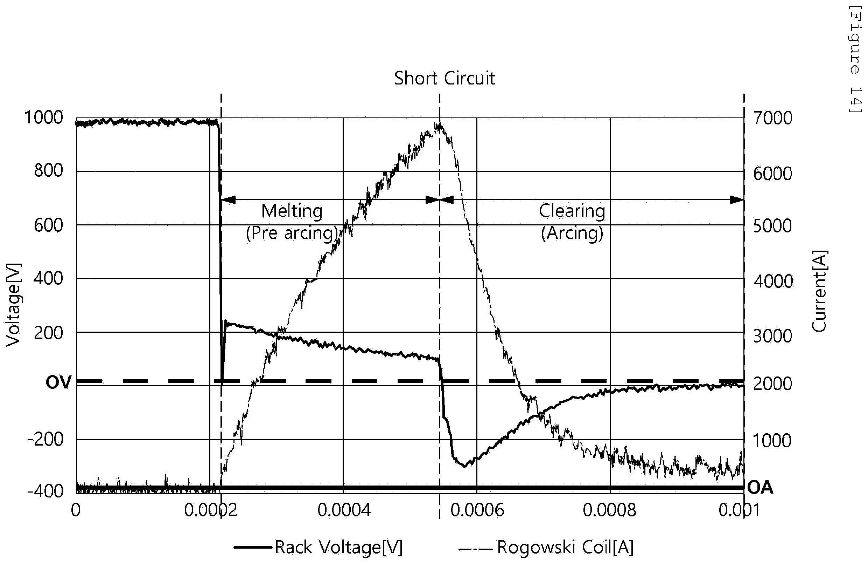

FIG. 14 is a graph showing a short circuit occurrence experiment in which a voltage-current change of the battery is measured according to a state of the fuse, according to embodiments of the present invention.

Referring to FIGs. 13 and 14, the short-circuit occurrence experiment data may be data obtained by pre-simulating a short-circuit current in a battery system according to a state of a fuse.

The processor 2000 may obtain values of parameters, such as voltage, resistance, and capacitor, except a total inductance $L_{total}$, from short-circuit occurrence experimental data, and apply the values to the short-circuit current prediction model.

Thereafter, the processor 2000 may extract a value of the remaining unknown inductance L from the short-circuit current prediction model to which the parameter values are applied S5300. For example, the inductance L may be calculated using curve fitting from a characteristic curve of the short-circuit current in section A illustrated in FIG. 12. Here, the inductance L may be a total inductance $L_{total}$ value obtained by adding an internal inductance $L_{ic}$ of the battery and an external inductance $L_{ec}$.

More specifically, according to embodiments, in the case of a battery system, the value of the inductance L may have a dominant influence initially due to a high frequency component. Accordingly, the processor 2000 may use a characteristic of the short-circuit voltage $V_{sc}$ that varies depending on a ratio of the inductance L, as shown in Equation 8 and Equation 9 below, to calculate an internal inductance $L_{ic}$ S5500. Here, an external inductance $L_{ec}$ may be given as experimental data.

[Equation 8]

$$V_{SC} = \frac{L_{ec}}{L_{total}} \times OCV$$

$L_{ec}$:     battery external inductance
$L_{total}$:     total inductance in battery system

[Equation 9]

$$L_{ic} = L_{total} - L_{ec}$$

$L_{ic}$: battery internal inductance

Thereafter, the processor 2000 may calculate the resistor value $R_{arc}$ inside the fuse with reference to Equation 10 below S5700.

[Equation 10]

$$R_{arc} = \frac{V_{sc}}{I_{sc}}$$

$I_{sc}$: short-circuit current

More specifically, according to the embodiments, the processor 2000, based on previously acquired short-circuit occurrence experimental data, may apply a magnitude ($V_{peak}$) of a voltage at which a counter electromotive force occurs and the short-circuit current value ($I_{sc}$) to the short-circuit current prediction model, to calculate the resistance value inside the fuse.

Thereafter, the processor 2000 may extract a value of the capacitor $C_{arc}$, which is one remaining unknown in the short-circuit current prediction model S5900. For example, the processor 2000 may extract a value of the capacitor $C_{arc}$ using curve fitting.

In summary, the processor 2000 may calculate all of the parameters of the short-circuit current prediction model in the first mode or in the second mode based on the previously acquired short-circuit occurrence experimental data. Thus, it is possible to accurately predict the short-circuit current reflecting both electrical characteristics of the battery and the electrical characteristics of the fuse in the battery system.

The short-circuit current prediction apparatus and method according to embodiments of the present invention have been described above.

The short-circuit current prediction apparatus and method according to embodiments of the present invention may derive an internal equivalent circuit of the battery that reflects a short circuit condition in a DC, derive a first equivalent circuit in consideration of electrical characteristics of the battery, derive a second equivalent circuit in consideration of electrical characteristics of the fuse, obtain a short-circuit current prediction model by reflecting the first equivalent circuit and the second equivalent circuit based on the internal equivalent circuit, and predict the short-circuit current according to a battery voltage using the short-circuit current prediction model. Thus, high-precision short-circuit current prediction is possible in units of battery modules, racks, and systems (banks) in consideration of both mechanical and chemical characteristics of a parallel-connected battery system and based on previously acquired short-circuit occurrence experimental data, therby providing a high-efficiency and low-cost short-circuit current prediction apparatus and method that can be used to determine a maximum number of parallel connections of batteries while developing a battery system, and thus, reducing a number of short-circuit occurrence experiments and preventing a delay of development schedule.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the scope of the present invention described in the appending claims.

**Claims**

1. An apparatus for predicting a short-circuit current in a battery system including a battery and a fuse for protecting the battery, the apparatus comprising:

at least one processor (2000); and
a memory (1000) configured to store at least one instruction executed by the at least one processor (2000), wherein the at least one instruction includes:

an instruction to derive an internal equivalent circuit of the battery that reflects a short circuit condition in a Direct Current, DC, circuit; **characterised by**
an instruction to derive a first equivalent circuit in consideration of one or more electrical characteristics of the battery;
an instruction to derive a second equivalent circuit in consideration of one or more electrical characteristics of the fuse;
an instruction to obtain a short-circuit current prediction model by reflecting the first equivalent circuit and the second equivalent circuit based on the internal equivalent circuit; and
an instruction to predict the short-circuit current according to a battery voltage using the short-circuit current prediction model.

2. The apparatus of claim 1, wherein the first equivalent circuit includes a circuit in which a first resistor and a second resistor are connected in series in the battery, the second resistor being connected in parallel with a capacitor.

3. The apparatus of claim 1, wherein the second equivalent circuit includes a switch and a circuit in which a resistor and a capacitor of the fuse are connected in series.

4. The apparatus of claim 3, wherein the switch represents a first state in which a conductor starts to melt by heat generated inside the fuse before an arc occurs or a second state in which the conductor melted due to occurrence of an arc and a current flows into the air, according to on/off state of the switch.

5. The apparatus of claim 4, wherein the instruction to obtain the short-circuit current prediction model includes:

an instruction to formulate the first equivalent circuit;
formulate the second equivalent circuit; and
an instruction to obtain the short-circuit current prediction model according to the first state or the second state by reflecting the formulated first equivalent circuit and the second equivalent circuit in the internal equivalent circuit and using short-circuit occurrence experimental data.

6. The apparatus of claim 1, wherein the internal equivalent circuit includes an internal resistor and an internal inductor of the battery based on an RL circuit.

7. The apparatus of claim 5, wherein the short-circuit current prediction model in the first state includes one or more mechanical characteristics of the battery in a transient state, and
the short-circuit current prediction model in the second state includes one or more mechanical characteristics of the battery in the transient state and one or more chemical characteristics of the battery in a stationary state.

8. A method for predicting a short-circuit current in a battery system including a battery and a fuse for protecting the battery, the method comprising:

Deriving (S1000) an internal equivalent circuit of the battery that reflects a short circuit condition in a Direct Current, DC, circuit; **characterised by**
deriving (S2000) a first equivalent circuit in consideration of one or more electrical characteristics of the battery;
deriving (S3000) a second equivalent circuit in consideration of one or more electrical characteristics of the fuse;
obtaining (S4000) a short-circuit current prediction model by reflecting the first equivalent circuit and the second equivalent circuit based on the internal equivalent circuit; and
predicting (S5000) a short-circuit current according to a battery voltage using the short-circuit current prediction model.

9. The method of claim 8, wherein the first equivalent circuit includes a circuit in which a first resistor and a second resistor are connected in series in the battery, the second resistor being connected in parallel with a capacitor.

10. The method of claim 8, wherein the second equivalent circuit includes a switch and a circuit in which a resistor and a capacitor of the fuse are connected in series.

11. The method of claim 10, wherein the switch represents a first state in which a conductor starts to melt by heat generated inside the fuse before an arc occurs, or a second state in which the conductor melted due to occurrence of an arc and a current flows into the air, according to an on/off state of the switch.

12. The method of claim 11, wherein the obtaining (S4000) the short-circuit current prediction model includes:

formulating (S4100) the first equivalent circuit;
formulating (S4300) the second equivalent circuit; and
obtaining (S4500) the short-circuit current prediction model according to the first state or the second state by reflecting the formulated first equivalent circuit and the second equivalent circuit in the internal equivalent circuit and using short-circuit occurrence experimental data.

13. The method of claim 8, wherein the internal equivalent circuit includes an internal resistor and an internal inductor of the battery based on an RL circuit.

14. The method of claim 12, wherein the short-circuit current prediction model in the first state includes mechanical properties of the battery in a transient state, and
the short-circuit current prediction model in the second state includes one or more mechanical characteristics of the battery in a transient state and one or more chemical characteristics of the battery in a stationary state.

**Patentansprüche**

1. Vorrichtung zum Vorhersagen eines Kurzschlussstroms in einem Batteriesystem, welches eine Batterie und eine Sicherung zum Schutz der Batterie umfasst, wobei die Vorrichtung umfasst:

wenigstens einen Prozessor (2000); und
einen Speicher (1000), welcher dazu eingerichtet ist, wenigstens eine Anweisung zu speichern, welche durch den wenigstens einen Prozessor (2000) ausgeführt wird,
wobei die wenigstens eine Anweisung umfasst:

eine Anweisung zum Ableiten einer internen Ersatzschaltung unter Berücksichtigung der Batterie, welche einen Kurzschlusszustand in einem Gleichstromkreis, DC-Kreis, reflektiert; **gekennzeichnet durch**
eine Anweisung zum Ableiten einer ersten Ersatzschaltung unter Berücksichtigung einer oder mehrerer elektrischer Eigenschaften der Batterie;
eine Anweisung zum Ableiten einer zweiten Ersatzschaltung unter Berücksichtigung einer oder mehrerer elektrischer Eigenschaften der Sicherung;
eine Anweisung zum Erhalten eines Kurzschlussstrom-Vorhersagemodells durch Reflektieren der ersten Ersatzschaltung und der zweiten Ersatzschaltung auf Grundlage der internen Ersatzschaltung; und
eine Anweisung zum Vorhersagen eines Kurzschlussstroms gemäß einer Batteriespannung unter Verwendung des Kurzschlussstrom-Vorhersagemodells.

2. Vorrichtung nach Anspruch 1, wobei die erste Ersatzschaltung eine Schaltung umfasst, in welcher ein erster Widerstand und ein zweiter Widerstand in Reihe in der Batterie geschaltet sind, wobei der zweite Widerstand parallel zu einem Kondensator geschaltet ist.

3. Vorrichtung nach Anspruch 1, wobei die zweite Ersatzschaltung einen Schalter und eine Schaltung umfasst, in welcher ein Widerstand und ein Kondensator der Sicherung in Reihe geschaltet sind.

4. Vorrichtung nach Anspruch 3, wobei der Schalter gemäß einem Ein-/Aus-Zustand des Schalters einen ersten Zustand, in welchem ein Leiter durch innerhalb der Sicherung erzeugte Wärme zu schmelzen beginnt, bevor ein Lichtbogen auftritt, oder einen zweiten Zustand repräsentiert, in welchem der Leiter aufgrund eines Auftretens eines Lichtbogens geschmolzen ist und ein Strom in die Luft fließt.

5. Vorrichtung nach Anspruch 4, wobei die Anweisung zum Erhalten des Kurzschlussstrom-Vorhersagemodells umfasst:

eine Anweisung zum Formulieren der ersten Ersatzschaltung
Formulieren der zweiten Ersatzschaltung; und
eine Anweisung zum Erhalten des Kurzschlussstrom-Vorhersagemodells gemäß dem ersten Zustand oder dem zweiten Zustand durch Reflektieren der formulierten ersten Ersatzschaltung und der formulierten zweiten Ersatzschaltung in der internen Ersatzschaltung und unter Verwendung experimenteller Daten zum Auftreten von Kurzschlüssen.

6. Vorrichtung nach Anspruch 1, wobei die interne Ersatzschaltung einen internen Widerstand und eine interne Induktivität der Batterie auf Grundlage einer RL-Schaltung umfasst.

7. Vorrichtung nach Anspruch 5, wobei das Kurzschlussstrom-Vorhersagemodell in dem ersten Zustand eine oder mehrere mechanische Eigenschaften der Batterie in einem Übergangszustand umfasst und

das Kurzschlussstrom-Vorhersagemodell in dem zweiten Zustand eine oder mehrere mechanische Eigenschaften der Batterie in dem Übergangszustand und eine oder mehrere chemische Eigenschaften der Batterie in einem stationären Zustand umfasst.

8. Verfahren zum Vorhersagen eines Kurzschlussstroms in einem Batteriesystem, welches eine Batterie und eine Sicherung zum Schutz der Batterie umfasst, wobei das Verfahren umfasst:

Ableiten (S1000) einer internen Ersatzschaltung unter Berücksichtigung der Batterie, welche einen Kurzschlusszustand in einem Gleichstromkreis, DC-Kreis, reflektiert; **gekennzeichnet durch**
Ableiten (S2000) einer ersten Ersatzschaltung unter Berücksichtigung einer oder mehrerer elektrischer Eigenschaften der Batterie;
Ableiten (S3000) einer zweiten Ersatzschaltung unter Berücksichtigung einer oder mehrerer elektrischer Eigenschaften der Sicherung;
Erhalten (S4000) eines Kurzschlussstrom-Vorhersagemodells durch Reflektieren der ersten Ersatzschaltung und der zweiten Ersatzschaltung auf Grundlage der internen Ersatzschaltung; und
Vorhersagen (S5000) eines Kurzschlussstroms gemäß einer Batteriespannung unter Verwendung des Kurzschlussstrom-Vorhersagemodells.

9. Verfahren nach Anspruch 8, wobei die erste Ersatzschaltung eine Schaltung umfasst, in welcher ein erster Widerstand und ein zweiter Widerstand in Reihe in der Batterie geschaltet sind, wobei der zweite Widerstand parallel zu einem Kondensator geschaltet ist.

10. Verfahren nach Anspruch 8, wobei die zweite Ersatzschaltung einen Schalter und eine Schaltung umfasst, in welcher ein Widerstand und ein Kondensator der Sicherung in Reihe geschaltet sind.

11. Verfahren nach Anspruch 10, wobei der Schalter gemäß einem Ein-/Aus-Zustand des Schalters einen ersten Zustand, in welchem ein Leiter durch innerhalb der Sicherung erzeugte Wärme zu schmelzen beginnt, bevor ein Lichtbogen auftritt, oder einen zweiten Zustand repräsentiert, in welchem der Leiter aufgrund eines Auftretens eines Lichtbogens geschmolzen ist und ein Strom in die Luft fließt.

12. Verfahren nach Anspruch 11, wobei das Erhalten (S4000) des Kurzschlussstrom-Vorhersagemodells umfasst:

Formulieren (S4100) der ersten Ersatzschaltung
Formulieren (S4300) der zweiten Ersatzschaltung; und
Erhalten (S4500) des Kurzschlussstrom-Vorhersagemodells gemäß dem ersten Zustand oder dem zweiten Zustand durch Reflektieren der formulierten ersten Ersatzschaltung und der formulierten zweiten Ersatzschaltung in der internen Ersatzschaltung und unter Verwendung experimenteller Daten zum Auftreten von Kurzschlüssen.

13. Verfahren nach Anspruch 8, wobei die interne Ersatzschaltung einen internen Widerstand und eine interne Induktivität der Batterie auf Grundlage einer RL-Schaltung umfasst.

14. Verfahren nach Anspruch 12, wobei das Kurzschlussstrom-Vorhersagemodell in dem ersten Zustand eine oder mehrere mechanische Eigenschaften der Batterie in einem Übergangszustand umfasst und

das Kurzschlussstrom-Vorhersagemodell in dem zweiten Zustand eine oder mehrere mechanische Eigenschaften der Batterie in dem Übergangszustand und eine oder mehrere chemische Eigenschaften der Batterie in einem stationären Zustand umfasst.

**Revendications**

1. Appareil de prédiction d'un courant de court-circuit dans un système de batterie comportant une batterie et un fusible pour protéger la batterie, l'appareil comprenant :

   au moins un processeur (2000) ; et
   une mémoire (1000) configurée pour stocker au moins une instruction exécutée par ledit au moins un processeur (2000),
   dans lequel ladite au moins une instruction comporte :

   une instruction de dérivation d'un circuit équivalent interne de la batterie qui reflète une condition de court-circuit dans un circuit à courant continu, CC ; **caractérisé par** une instruction de dérivation d'un premier circuit équivalent en tenant compte d'une ou plusieurs caractéristiques électriques de la batterie ;
   une instruction de dérivation d'un second circuit équivalent en tenant compte d'une ou plusieurs caractéristiques électriques du fusible ;
   une instruction d'obtention d'un modèle de prédiction de courant de court-circuit en reflétant le premier circuit équivalent et le second circuit équivalent sur la base du circuit équivalent interne ; et
   une instruction de prédiction du courant de court-circuit en fonction d'une tension de batterie à l'aide du modèle de prédiction de courant de court-circuit.

2. Appareil selon la revendication 1, dans lequel le premier circuit équivalent comporte un circuit dans lequel une première résistance et une seconde résistance sont connectées en série dans la batterie, la seconde résistance étant connectée en parallèle à un condensateur.

3. Appareil selon la revendication 1, dans lequel le second circuit équivalent comporte un commutateur et un circuit dans lequel une résistance et un condensateur du fusible sont connectés en série.

4. Appareil selon la revendication 3, dans lequel le commutateur représente un premier état dans lequel un conducteur commence à fondre par de la chaleur générée à l'intérieur du fusible avant qu'un arc ne se produise ou un second état dans lequel le conducteur a fondu en raison de l'apparition d'un arc et un courant circule dans l'air, en fonction de l'état marche/arrêt du commutateur.

5. Appareil selon la revendication 4, dans lequel l'instruction d'obtention du modèle de prédiction de courant de court-circuit comporte :

   une instruction d'élaboration du premier circuit équivalent ;
   d'élaboration du second circuit équivalent ; et
   une instruction d'obtention du modèle de prédiction de courant de court-circuit en fonction du premier état ou du second état en reflétant le premier circuit équivalent élaboré et le second circuit équivalent dans le circuit équivalent interne et en utilisant des données expérimentales d'occurrence de court-circuit.

6. Appareil selon la revendication 1, dans lequel le circuit équivalent interne comporte une résistance interne et un inducteur interne de la batterie sur la base d'un circuit RL.

7. Appareil selon la revendication 5, dans lequel le modèle de prédiction de courant de court-circuit dans le premier état comporte une ou plusieurs caractéristiques mécaniques de la batterie dans un état transitoire, et
   le modèle de prédiction de courant de court-circuit dans le second état comporte une ou plusieurs caractéristiques mécaniques de la batterie dans l'état transitoire et une ou plusieurs caractéristiques chimiques de la batterie dans un état stationnaire.

8. Procédé de prédiction d'un courant de court-circuit dans un système de batterie comportant une batterie et un fusible pour protéger la batterie, le procédé comprenant :

la dérivation (S1000) d'un circuit équivalent interne de la batterie qui reflète une condition de court-circuit dans un circuit à courant continu, CC ; **caractérisé par**
la dérivation (S2000) d'un premier circuit équivalent en tenant compte d'une ou plusieurs caractéristiques électriques de la batterie ;
la dérivation (S3000) d'un second circuit équivalent en tenant compte d'une ou plusieurs caractéristiques électriques du fusible ;
l'obtention (S4000) d'un modèle de prédiction de courant de court-circuit en reflétant le premier circuit équivalent et le second circuit équivalent sur la base du circuit équivalent interne ; et
la prédiction (S5000) d'un courant de court-circuit selon une tension de batterie à l'aide du modèle de prédiction de courant de court-circuit.

9. Procédé selon la revendication 8, dans lequel le premier circuit équivalent comporte un circuit dans lequel une première résistance et une seconde résistance sont connectées en série dans la batterie, la seconde résistance étant connectée en parallèle à un condensateur.

10. Procédé selon la revendication 8, dans lequel le second circuit équivalent comporte un commutateur et un circuit dans lequel une résistance et un condensateur du fusible sont connectés en série.

11. Procédé selon la revendication 10, dans lequel le commutateur représente un premier état dans lequel un conducteur commence à fondre par de la chaleur générée à l'intérieur du fusible avant qu'un arc ne se produise, ou un second état dans lequel le conducteur a fondu en raison de l'apparition d'un arc et un courant circule dans l'air, en fonction d'un état marche/arrêt du commutateur.

12. Procédé selon la revendication 11, dans lequel l'obtention (S4000) du modèle de prédiction de courant de court-circuit comporte :

l'élaboration (S4100) du premier circuit équivalent ;
l'élaboration (S4300) du second circuit équivalent ; et
l'obtention (S4500) du modèle de prédiction de courant de court-circuit en fonction du premier état ou du second état en reflétant le premier circuit équivalent élaboré et le second circuit équivalent dans le circuit équivalent interne et en utilisant des données expérimentales d'occurrence de court-circuit.

13. Procédé selon la revendication 8, dans lequel le circuit équivalent interne comporte une résistance interne et un inducteur interne de la batterie sur la base d'un circuit RL.

14. Procédé selon la revendication 12, dans lequel le modèle de prédiction de courant de court-circuit dans le premier état comporte

des propriétés mécaniques de la batterie dans un état transitoire, et
le modèle de prédiction de courant de court-circuit dans le second état comporte une ou plusieurs caractéristiques mécaniques de la batterie dans un état transitoire et une ou plusieurs caractéristiques chimiques de la batterie dans un état stationnaire.

[Figure 1]

[Figure 2]

[Figure 3]

[Figure 4]

Equivalent Model

Melting: ① Switch ON, ② Switch OFF

Clearing: ① Switch OFF, ② Switch ON

[Figure 5]

```
                          ┌─────────────┐
                          │    start    │
                          └─────────────┘
                                 │
                                 ▼
        ┌──────────────────────────────────────────┐
        │     obtain internal equivalent circuit    │───── S1000
        └──────────────────────────────────────────┘
                                 │
                                 ▼
        ┌──────────────────────────────────────────┐
        │       obtain first equivalent circuit     │───── S2000
        └──────────────────────────────────────────┘
                                 │
                                 ▼
        ┌──────────────────────────────────────────┐
        │      obtain second equivalent circuit     │───── S3000
        └──────────────────────────────────────────┘
                                 │
                                 ▼
        ┌ ─ ─ ─ ─ ─ ─ ─ ─ ─ ─ ─ ─ ─ ─ ─ ─ ─ ─ ─ ─ ┐
              obtain short-circuit current            ───── S4000
        │       prediction model                    │
          ┌──────────────────────────────────────┐
        │ │    formulate first equivalent circuit │ ┤───── S4100
          └──────────────────────────────────────┘
        │                  │                        │
                           ▼
        │ ┌──────────────────────────────────────┐ │
          │  formulate second equivalent circuit  │─┤───── S4300
        │ └──────────────────────────────────────┘ │
                           │
        │                  ▼                        │
          ┌──────────────────────────────────────┐
        │ │ obtain short-circuit current          │ ┤───── S4500
          │ prediction model in first mode or     │
        │ │ second mode                           │ │
          └──────────────────────────────────────┘
        └ ─ ─ ─ ─ ─ ─ ─ ─ ─│─ ─ ─ ─ ─ ─ ─ ─ ─ ─ ─ ┘
                           ▼
        ┌──────────────────────────────────────────┐
        │       predict short-circuit current       │───── S5000
        └──────────────────────────────────────────┘
                           │
                           ▼
                    ┌─────────────┐
                    │     end     │
                    └─────────────┘
```

[Figure 6]

Equivalent Circuit

[Figure 7]

$$I_{max} = \frac{OCV}{R}$$

Voltage

Current

Switch OFF    Switch ON    Switch

[Figure 8]

Battery Equivalent Circuit

[Figure 9]

Fuse Equivalent Circuit

[Figure 10]

[Figure 11]

$V_{peak} \approx I \times R_{arc}$

Current

Voltage

Switch

Switch 1 ON

Switch 2 ON

[Figure 12]

[Figure 13]

```
                        ┌──────────┐
                        │  start   │
                        └────┬─────┘
                             │
                             ▼
        ┌────────────────────────────────────────────┐
        │   apply parameters except inductance        │──── S5100
        └────────────────────┬───────────────────────┘
                             │
                             ▼
        ┌────────────────────────────────────────────┐
        │        calculate total inductance           │──── S5300
        └────────────────────┬───────────────────────┘
                             │
                             ▼
        ┌────────────────────────────────────────────┐
        │       calculate internal inductance         │──── S5500
        └────────────────────┬───────────────────────┘
                             │
                             ▼
        ┌────────────────────────────────────────────┐
        │     calculate resistor value inside fuse    │──── S5700
        └────────────────────┬───────────────────────┘
                             │
                             ▼
        ┌────────────────────────────────────────────┐
        │    calculate capacitor value inside fuse    │──── S5900
        └────────────────────┬───────────────────────┘
                             │
                             ▼
                        ┌──────────┐
                        │   end    │
                        └──────────┘
```

[Figure 14]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 111585270 A

**Non-patent literature cited in the description**

- Arc-flash in large battery energy storage systems - Hazard calculation and mitigation. **GATTAF M et al.** 2016 IEEE 16TH INTERNATIONAL CONFERENCE ON ENVIRONMENT AND ELECTRICAL ENGINEERING (EEEIC). IEEE, 07 June 2016, 1-6